# EUROPEAN PATENT APPLICATION

(11) **EP 4 513 535 A2**
(43) Date of publication of application: **26.02.2025**
(21) Application number: 24195779.4
(22) Date of filing: 22.08.2024
(51) Int. Cl.: H01L 21/67, H01L 21/677

(54) **APPARATUS CONSTRUCTED AND ARRANGED TO PROCESS A PLURALITY OF SUBSTRATES**

(30) Priority: 25.08.2023 US 202363578709 P
(71) Applicant: ASM IP Holding B.V., 1322 AP Almere (NL)
(72) Inventor: JDIRA, Lucian, 1322 AP Almere (NL); VAN EIJDEN, Johannes Maria Theodorus, 1322 AP Almere (NL); OOSTERLAKEN, Theodorus G.M., 1322 AP Almere (NL); KEIJSER, Julien Laurentius Antonius Maria, 1322 AP Almere (NL); BANKRAS, Radko, 1322 AP Almere (NL); TERHORST, Herbert, 1322 AP Almere (NL)
(74) Representative: V.O.

(57) **Abstract**

An apparatus (1) for processing a plurality of substrates (3) is provided. The apparatus may have a process tube (5) creating a process chamber (7) and a door (15) configured to support substrates (3) in the process chamber and to seal the process chamber (7). The apparatus may have a gas injector (23) to provide process gas into the process chamber. The gas injector may be operably connected to a process gas line (27) in a purge chamber (9) to purge the connection between the gas injector (23) and the process gas line (27).

## Description

### Field

The disclosure relates to an apparatus constructed and arranged to process a plurality of substrates. More in particular the disclosure relates to an apparatus, comprising;
a process tube creating a process chamber;
a gas injector to provide process gas into the process chamber; and,
a door configured to support a wafer boat with a plurality of substrates in the process chamber.

### Background

Semiconductor substrates can be processed in batches in vertical furnaces. An example of such processing is the reaction of layers of various materials on the substrates in a process chamber at elevated temperature. The process tube creating the process chamber may be provided with, for example, hydrogen as the process gas.

The apparatus may comprise a gas injector to provide the process gas into the process chamber. The gas injector may be operably connected to a process gas line. A connection between the gas injector and the process gas line may form a risk for leakage of hydrogen. Oxygen may react with the leaking hydrogen creating a safety risk.

### Summary

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It may be an objective to provide an apparatus in which the risk of hydrogen reacting with oxygen may be minimized.

According to an aspect there may be provided an apparatus constructed and arranged to process a plurality of substrates. The apparatus may have a process tube creating a process chamber and a gas injector to provide process gas into the process chamber. A door configured to support a wafer boat with a plurality of substrates in the process chamber and to seal the process chamber may be provided. The gas injector may be operably connected to a process gas line. A purge chamber connected to an inert gas source may be provided. The gas injector may be operably connected to a process gas line in the purge chamber to purge a connection between the gas injector and the process gas line.

For purposes of summarizing the invention and the advantages achieved over the prior art, certain objects and advantages of the invention have been described herein above. Of course, it is to be understood that not necessarily all such objects or advantages may be achieved in accordance with any particular embodiment of the invention. Thus, for example, those skilled in the art will recognize that the invention may be embodied or carried out in a manner that achieves or optimizes one advantage or group of advantages as taught or suggested herein without necessarily achieving other objects or advantages as may be taught or suggested herein.

All of these embodiments are intended to be within the scope of the invention herein disclosed. These and other embodiments will become readily apparent to those skilled in the art from the following detailed description of certain embodiments having reference to the attached figure, the invention not being limited to any particular embodiment(s) disclosed.

### Brief description of the figures

While the specification concludes with claims particularly pointing out and distinctly claiming what is regarded as embodiments, the advantages of embodiments of the disclosure may be more readily ascertained from the description of certain examples of the embodiments of the disclosure when read in conjunction with the accompanying drawing, in which:
Figure 1a is a schematic and cross-sectional side view on an apparatus for processing a plurality of substrates in a closed condition according to embodiments of the present invention;
Figure 1b is a further schematic and cross-sectional side view on an apparatus for processing a plurality of substrates in a closed condition according to embodiments of the present invention; and
Figure 2 is a schematic view of a dilution gas flow line which may be comprised in embodiments of the present invention.

### Detailed description

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below. The illustrations presented herein are not meant to be actual views of any particular material, structure, or device, but are merely idealized representations that are used to describe embodiments of the disclosure.

As used herein, the term "substrate" or "wafer" may refer to any underlying material or materials that may be used, or upon which, a device, a circuit, or a film may be formed. The term "semiconductor device structure" may refer to any portion of a processed, or partially processed, semiconductor structure that is, includes, or defines at least a portion of an active or passive component of a semiconductor device to be formed on or in a semiconductor substrate.

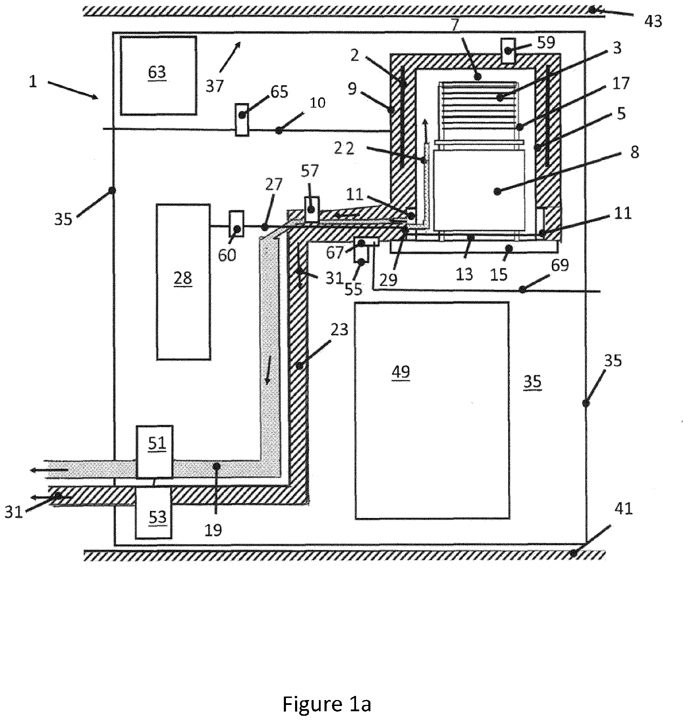

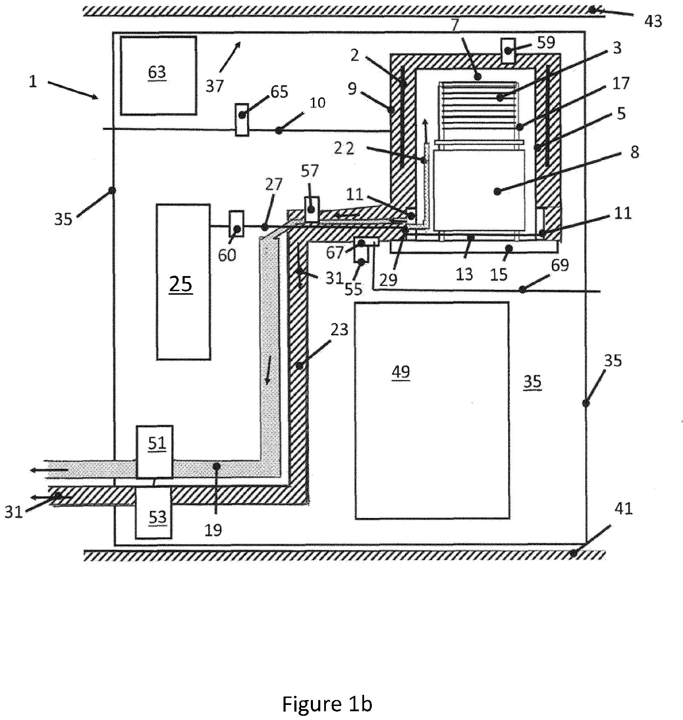

Semiconductor substrates can be processed in batches. Figures 1a and 1b illustrate schematically a portion of an exemplary batch reactor. The illustrated reactor may be a vertical furnace type of reactor, which has benefits for efficient heating and loading.

Figures 1a and 1b show schematic and cross-sectional side views on a process tube 5 of an apparatus 1 for processing a plurality of substrates 3 e.g. vertical furnace in a closed condition. The apparatus may have a process tube 5 creating a process chamber 7. The process tube 5 may be open at the bottom and closed at the top in a dome shape (not shown).

Optionally, a purge chamber 9 surrounding the process tube 5 for purging the outside of the process tube 5 may be provided. The purge chamber 9 may be connected to an inert gas source via a purge line 10 to purge an outside of the process tube 5. The purge line 10 may connect to a tank or an inert gas line from a factory in which the apparatus 1 is used, as the inert gas source.

A pedestal 8 may support a wafer boat 17, which holds a plurality of wafers 3, preferably between 50 and 200 wafers in the process chamber 7. The pedestal 8 may be thermally insulating, to prevent undue heating of a surrounding part of the vertical furnace including a door 15 supporting the pedestal 8. The inside of the door 15 may be purged as well. This may be done with nitrogen.

The process tube 5 may have a base which may be supported on a flange 11. There may be provided seals between the process tube 5 and the flange 11 to close of the process chamber. Additional flanges 11 may be used surrounding and or supporting the process tube 5 to seal it off. Flanges 11 may also be used to support other components in the process tub such as an injector or liner. The flange 11 for supporting the process tube 5 may be provided with a flange opening 13 giving access to an opening of the process tube 5.

A wafer boat 17 with substrates 3 may be moved into the process chamber 7 via the flange opening 13 while being supported on the door 15. At the end of the movement the door 15 while supporting the wafer boat 17 with a plurality of substrates 3 in the process chamber may seal the process chamber 7. The apparatus may have an exhaust operably connected to the process chamber 7 to remove gas from the process chamber via a process gas exhaust duct 19. The process gas exhaust duct 19 may connect to the process chamber 7 via a hole in the flange 11.

The purge chamber 9 may extended to partially surround the flange 11. The purge chamber 9 may also surround the process gas exhaust duct 19 partially at least where it connects to the process chamber 7. In other words, a connection between the process gas exhaust duct 19 and the process chamber 7 may be at least partially surrounded by the purge chamber 9 to allow the connection between the process gas exhaust duct 19 and the process chamber to be purged. The purge chamber 9 may be connected to a purge exhaust duct 23 to remove gas from the purge chamber 21. In this way any process gases that may leak out of the process chamber 7, the purge chamber 9 or the process gas exhaust duct 19 at the connection to the process chamber 7 may be pumped away with the purge pump 53.

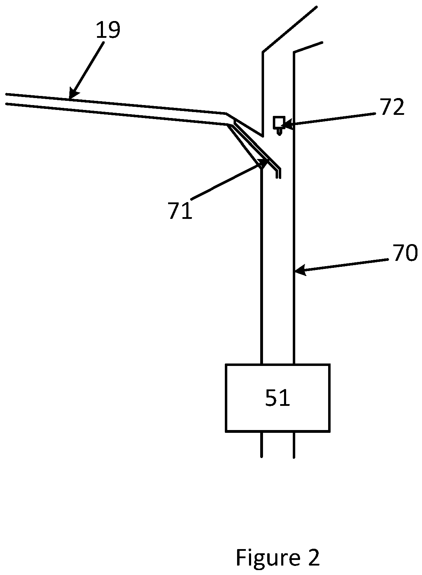

Referring to Figure 2, in some embodiments, the process gas exhaust duct 19 may be connected to a dilution gas line 70 via an injection pipe 71 for injecting gas from the process gas exhaust duct 19 into a dilution gas flow in the dilution gas line 70 at an injection point P. The dilution gas line 70 may be configured to provide a flow of a dilution gas which may be air. The dilution gas line may provide a high flow rate of the dilution gas, for example at least 1500 standard litres per minute (slm). The dilution gas line 70 may include a nitrogen injection nozzle 72 for injecting nitrogen gas into the flow of the dilution gas. The nitrogen injection nozzle 72 may be provided upstream of the injection point P. The nitrogen injection nozzle 72 may provide a flow rate of at least 60 slm or at least 70 slm of nitrogen into the flow of the dilution gas. The nitrogen gas flow promotes turbulent mixing of the process gas exhausted through the injection pipe 71 with the dilution gas flow. This may allow for dilution of the process gas, for example hydrogen, from 100% concentration to < 4% concentration in less than one second. The gas flow through the dilution gas line 70 may then be exhausted via the process gas pump 51.

By providing a high flow of air in combination with injection of nitrogen at a high flow rate into the air flow, the amount of nitrogen required for diluting the exhausted process gas to safe levels may be reduced.

Referring again to Figures 1a and 1b, the apparatus may comprise a gas injector 22 to provide process gas into the process chamber 7. The gas injector 22 may be operably connected to a process gas line 27 in the purge chamber 9 so that the connection between the gas injector 22 and the process gas line 27 may be in a purged environment. By connecting the gas injector 22 to the process chamber 7 via the purge chamber 9 leakage of process gas into the rest of the apparatus 1 may be prevented. Further, because the purge chamber 9 is purged no oxygen may be present in the purge chamber 9 so that a reaction between hydrogen and oxygen may be circumvented.

The apparatus may be provided with a hydrogen source, e.g. from a tank 28 (Figure 1a) or a line from a factory where the apparatus is used. The hydrogen may be provided to the process chamber 7 via the process gas line 27 and the gas injector 22. The hydrogen may be used in the process chamber to perform a hydrogen anneal process. The hydrogen anneal process may be performed at high temperature e.g. 300 to 700°C, preferably 400 to 600°C.

By connecting the process gas line 27 to the gas injector 22 in the purge chamber 9 the risk of leakage of process gas into the rest of the apparatus 1 may be minimized if the connection may leak. The purge chamber 9 may be constructed and arranged to purge an outside of the connection between the process gas line 27 and the gas injector 22. The connection may be made with for example a ball joint 29 and the risk of leakage of process gas into the rest of the apparatus 1 may be minimized if the joint may leak in the purge chamber 9.

When the process gas is hydrogen and it leaks into a high temperature environment where oxygen is present there is an immediate risk of a reaction creating thermal energy and damage to the apparatus. The latter can result in a safety hazard situation which should be avoided.

To assure that the hydrogen in the process chamber 7, the process gas line 27, the gas injector 22 and the process gas exhaust duct 19 may not react with oxygen when something leaks there may be provided the purge chamber 9. The purge chamber may be filled with an inert gas to assure that there is no oxygen in the environment where the hydrogen may leak to.

The hydrogen may be diluted with inert gas to alleviate the risk of a reaction with oxygen. It may be exhausted after sufficient dilution via purge exhaust duct 23. The purge exhaust duct 23 may be connected to a purge pump 53 to remove gases from the purge chamber 9 to outside the apparatus. The flows 31 may transport any leaking gasses to the purge exhaust duct 23 and purge pump 53.

A heater 2 surrounding the process tube for heating the process chamber 7 may be provided. The heater 2 may be provided in the purge chamber 9. Any outgassing products of the heater 2 may be pumped away with the purge pump 53 via the purge chamber 9 and the purge exhaust duct 23.

A heat exchanger (not shown) may be provided to the apparatus 1 to cool down the inert gas in the purge chamber 9. This may be done if a cool down of the processing chamber 7 may be required, for example at the end of a production run.

Referring in particular to Figure 1b, the apparatus 1 may be provided with a process gas production unit 25 operably connected via a process gas line 27 to the gas injector 22 to produce process gas and to provide it into the process chamber 7. By providing the gas production unit 25 in the purge chamber 9 leakage of process gas into the rest of the apparatus 1 may be circumvented when the gas production unit 25 may leak.

Referring again to Figures 1a and 1b, the apparatus may be provided with a sidewall 35 to limit access to the apparatus 1. The apparatus may be provided with a plurality of sidewalls 35 to create an open box which is open at the top 37.

Also the bottom may be left open. At the bottom drop collection buckets may be provided optionally to collect any leaking liquids. The open box structure may function as a protective cover protecting the inside of the apparatus 1. This may be done for safety purpose.

Since the open box structure may not need a ceiling there is more space for the process chamber 7 between the floor 41 and the ceiling 43 of the factory where the apparatus 1 may be used. The process chamber 7 may accordingly become bigger and more wafers may be processed in the process chamber 7 in one go making the apparatus 1 more economic.

Equally the apparatus 1 may be provided with sidewalls 35 at the front and back. The sidewalls 35 may be connected to provide the open box structure. The apparatus 1 may be provided with a tool door 49 in the sidewall 35 giving access for maintenance. Maintenance worker may access the tool via the tool door 49.

The purge chamber 9 may be provided with a purge chamber door for giving access to the process gas line 27 and the process gas exhaust duct 19 and/or any other device in the purge chamber 21. Maintenance worker may access the process gas line 27, process gas exhaust duct 19 and/or any other device in the purge chamber 9 via the purge chamber door.

A purge measurement device 55 constructed and arranged for measuring a property of gas in the purge chamber 9 may be provided. The purge measurement device 55 may be provided near the purge gas exhaust duct.

The purge measurement device 55 may be constructed and arranged to measure a concentration of oxygen in the inert gas. It may alternatively be constructed and arranged to detect a certain oxygen level in the inert gas.

The purge measurement device 55 may be connected to a three way valve 67 to test the purge measurement device 55. The three way valve 67 may be in normal operation be connected to the purge gas exhaust duct 23 but may tested once in a while by connecting it to an air gas line 69 with a premixed test gas or plain air. The premixed gas may be nitrogen with a small percentage of oxygen e.g. 600 PPM oxygen. The small percentage of oxygen in the PPM range may assure good testing while at the same time ensuring that purging the three way valve 67 and purge measurement device 55 after the test will not take too much time.

The purge measurement device 55 may be constructed and arranged to detect hydrogen in the inert gas of the purge chamber 9. Measuring hydrogen may be additionally or alternatively to measuring oxygen.

The purge measurement device 55 may be constructed and arranged to detect or measure nitrogen in the purge chamber 9 if nitrogen is used as the inert gas. Measuring nitrogen may be additionally or alternatively to measuring oxygen and/or hydrogen. Measuring all three gas concentrations may make the measurement failsafe because with a measurement of 100% nitrogen the measurement of oxygen and hydrogen should be 0% which may give double security. In the latter situation it becomes possible to check the function of the purge measurement device 55.

Alternatively, a top purge measurement device 59 may be on the top of the purging chamber 9.

The inert gas used in the purge chamber 9 may be nitrogen. Alternatively, argon, helium, carbon dioxide or mixtures thereof may be considered. Mixtures may also include nitrogen.

A process gas measurement device 57 may be constructed and arranged for measuring a property of gas in the process chamber 7. The process gas measurement device 57 may be provided near the process gas exhaust duct 19. The process gas measurement device 57 may be constructed and arranged to detect oxygen as the measurement of the property of the process gas.

The process gas measurement device 57 may also be connected to a three way valve to test the process gas measurement device 57. The three way valve may be in normal operation be connected to the process gas exhaust duct but may tested once in a while by connecting it to a line with a premixed test gas or plain air. The premixed gas may be nitrogen with a small percentage of oxygen e.g. 600 PPM oxygen. The small percentage of oxygen in the PPM range assures good testing while at the same time ensuring that purging the three way valve and process gas measurement device 57 after the test will not take too much time.

The apparatus may be provided with a process gas valve 60. The process gas valve 60 may be in the process gas line 27 for controlling the process gas flow through the gas injector 22. A controller 63 may be operable connected to the process gas valve 60, the purge measurement device 55 and the process gas measurement device 53. The controller may controller 61 may control the process gas valve 60 to shut down process gas going to the injector 22 when oxygen is detected in the purge gas or the process gas by the purge measurement device 55 and/or the process gas measurement device 57. A part of the process gas valve 60 may be provided in the purge chamber 9 so that any leakage of process gas near the process gas valve 60 may flow in the purge exhaust duct 23.

The apparatus 1 may be provided with an inert gas valve 65 in the purge gas line 10 between the purge chamber 9 and the inert gas source to control supply of inert gas to the purge chamber 9.

The controller 61 may be operationally connected to the inert gas valve 65, the air gas valve 67 and the purge measurement device 55 constructed and arranged for measuring oxygen in the purge chamber 9. The controller 61 may be programmed to open the air gas valve to check the working of the measurement device 55 in measuring the presence of oxygen in the purge chamber 9. This may be done when the process gas valve 60 is closed for a while and the door 15 is opened. If the measurement device 55, in such circumstances, is not measuring the presence of oxygen in the purge chamber 9 it is broken and the controller 61 may signal that to a user to stop processing substrates and repair the measurement device 55.

The process chamber 7 may be an atmospheric process chamber operated at about 1 Atm. For example, at a pressure between 0.9 and 1.1 Atm, preferably 0.98 and 1.02 Atm and even more preferably at 0.99 to 1.01 ATM. These atmospheric process chambers may be sensitive to leakage since they are not substantially over pressurized.

The process gas exhaust duct 19 may be connected to process gas pump 51 to remove gases from the process chamber 7. The process gas pump 51 may be controlled to maintain the pressure at about 1 Atm such as between 0.9 and 1.1 Atm, preferably 0.98 and 1.02 Atm.

An elevator (not shown) operably connected to the controller 61 may be provided to move, e.g., lift or lower, the door 15, pedestal 8 and wafer boat 17 to load or unload the wafer boat 17. Gases, including inert and reactive precursor gases, may be provided to the process chamber 7 from gas sources, which may comprise a plurality of containers for holding various gases. Holes may be provided in the flange 11 to provide the processing gas from the gas source to the process chamber 7 with for example an injector 22. A hole in the flange 11 may also be used to remove gases from the process chamber 7. The purge chamber 9 may be used to circumvent the risk of leaks by purging the connections where the holes are.

The temperature inside the process chamber 7 may be measured using thermocouples. At higher temperature thermocouples may oxidize, resulting in a drift of the measured temperature or even breakage of the thermocouples. The rate of oxidation may depend on the temperature, oxygen level and possible catalysts, for example acids, in the environment.

The thermocouple may be located inside a quartz bulge or tube to isolate them from the process gas in the process chamber 7. The entrance of the quartz bulge may be open to the surrounding atmosphere to allow expanding gas in the quartz bulge during heat up to escape and/or gas to enter during cooldown. This may be necessary to prevent the quartz bulge to break due to high or low pressure inside the quartz bulge.

In deposition tools without purge chamber 9 it may be advantageous to provide an inert gas purge to the interior of the quartz bulge or tube housing the thermocouple. This may isolate the thermocouple from oxygen. The quartz bulge or tube may be closed and an overpressure relieve valve may be provided to allow expanding gas to escape from the quartz bulge or tube during heat-up while keeping the quartz tube purged with inert gas. The purge gas provided may also keep the bulge filled with purge gas during cool down.

In deposition tools with purge chamber 9 the entrance of the bulge or tube housing the thermocouple may also be connected to the purge chamber 9 to isolate the thermocouple from oxygen. This solution provides a protective environment for the thermocouple to prevent oxidation and to extend the lifetime.

Although illustrative embodiments of the present invention have been described above, in part with reference to the accompanying drawing, it is to be understood that the invention is not limited to these embodiments. Variations to the disclosed embodiments can be understood and effected by those skilled in the art in practicing the claimed invention, from a study of the drawing, the disclosure, and the appended claims.

Reference throughout this specification to "one embodiment" or "an embodiment" means that a particular feature, structure or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, it is noted that particular features, structures, or characteristics of one or more embodiments may be combined in any suitable manner to form new, not explicitly described embodiments.

## Claims

1. An apparatus (1) constructed and arranged to process a plurality of substrates (3), comprising;
a process tube (5) creating a process chamber (7);
a gas injector (22) to provide process gas into the process chamber (7); and
a door (15) configured to support a wafer boat (17) with a plurality of substrates (3) in the process chamber (7) and to seal the process chamber (7), wherein the apparatus (1) comprises a purge chamber (9) connected to an inert gas source and wherein the gas injector (22) is operably connected to a process gas line (27) at an injector-gas line connection, the injector-gas line connection being located in the purge chamber (9) so as to allow the injection-gas line connection to be purged.

2. The apparatus according to claim 1, wherein the purge chamber (9) is connected to a purge exhaust duct (23) to remove purge gas from the purge chamber (9).

3. The apparatus according to claim 1 or 2, wherein the apparatus (1) is provided with a hydrogen source to provide hydrogen to the process chamber (7) via the process gas line (27) and the gas injector (22).

4. The apparatus according to any one of claims 1-3, wherein the purge chamber (9) is constructed and arranged to surround the process tube (5).

5. The apparatus according to claim 4, wherein the apparatus (1) comprises a heater (2) surrounding the process tube (5) to heat the process chamber (7) and the heater (2) is provided in the purge chamber (9).

6. The apparatus according to any one of claims 1-5, wherein the apparatus (1) comprises a process gas exhaust duct (19) operably connected to the process chamber (7) to remove gas from the process chamber (7).

7. The apparatus according to claim 6, wherein the apparatus (1) comprises a flange (11) for supporting the process tube (5) and provided with a flange opening (13) giving access to an opening of the process chamber (7), wherein the process gas exhaust duct (19) is operably connected to the process chamber (7) to remove gas from the process chamber (7) via a hole in the flange (11), wherein the connection between the process gas exhaust duct (19) and the process chamber (7) is surrounded by the purge chamber (9) to allow the connection between the process gas exhaust duct (19) and the process chamber (7) to be purged.

8. The apparatus according to claim 6 or 7, wherein the apparatus (1) comprises a dilution gas flow line (70), the process gas exhaust duct (19) being coupled to the dilution gas flow line (70) so as to inject a gas removed from the process chamber (7) into the dilution gas flow line (70), and wherein the apparatus (1) comprises a nozzle (72) for injecting nitrogen gas into the dilution gas flow line (70) upstream of a point (P) at which the gas removed from the process chamber (7) is injected into the dilution gas flow line (70).

9. The apparatus according to any one of claims 1-8, wherein a purge measurement device (55) constructed and arranged for measuring a property of gas in the purge chamber (9) is provided.

10. The apparatus according to claim 9, wherein the purge measurement device (55) is constructed and arranged to measure a concentration of oxygen.

11. The apparatus according to claim 9 or 10, wherein the purge measurement device (55) is constructed and arranged to detect hydrogen.

12. The apparatus according to any one of claims 9-11, wherein the purge measurement device (55) is constructed and arranged to detect nitrogen.

13. The apparatus according to any one of claims 1-12, wherein a process gas measurement device (57) constructed and arranged for measuring a property of gas in the process chamber (7) is provided.

14. The apparatus according to claim 13, wherein the process gas measurement device (57) is constructed and arranged to detect oxygen.

15. The apparatus according to any one of claims 1-14, wherein the apparatus (1) is provided with an inert gas valve (65) between the purge chamber (9) and the inert gas source to control supply of inert gas to the purge chamber (9).

16. The apparatus according to claim 15, wherein the apparatus (1) is provided with an air gas valve (67) between the purge chamber (9) and a supply of air to control supply of air to the purge chamber (9).

17. The apparatus according to any one of claims 1-16, wherein the apparatus (1) is provided with a process gas valve (60) between the process chamber (7) and the process gas source to control supply of process gas to the process chamber (7).

18. The apparatus according to claim 16, wherein the apparatus (1) comprises a controller (61) operationally connected to the inert gas valve (65), the air gas valve (67) and a measurement device (55) constructed and arranged for measuring oxygen in the purge chamber (7), wherein the controller (61) is programmed to close the inert gas valve (65) and open the air gas valve (67) to check a working of a measurement device (55) in measuring a presence of oxygen in the purge chamber (7).

19. The apparatus according to any one of claims 1-18, wherein the process chamber (7) is an atmospheric process chamber (7) operated at a pressure about 1 Atm.

20. The apparatus according to any one of claims 1-19, wherein the purge chamber (9) is constructed and arranged to purge an outside of the connection between the process gas line (27) and the gas injector (22).
